# FASCICULE DE BREVET EUROPEEN

(11) **EP 4 345 671 B1**
(45) Date de publication et mention de la délivrance du brevet: **02.12.2026**
(21) Numéro de dépôt: 22306442.9
(22) Date de dépôt: 28.09.2022
(51) Int. Cl.: G06F 30/13, G06F 30/10, G06F 30/12, G06F 30/17

(54) **PROCEDE DE CONCEPTION D'OUVRAGE ARCHITECTURAL ASSISTEE PAR ORDINATEUR ET PRODUIT-PROGRAMME ASSOCIE A UN TEL PROCEDE**
VERFAHREN ZUM ENTWURF EINES COMPUTERGESTÜTZTEN ARCHITEKTONISCHEN BUCHES UND COMPUTERPROGRAMMPRODUKT DAFÜR
METHOD FOR DESIGNING AN ARCHITECTURAL COMPUTER-AIDED STRUCTURE AND PROGRAM PRODUCT ASSOCIATED WITH SUCH A METHOD

(43) Date de publication de la demande: 03.04.2024
(73) Titulaire: Krichene, Eslem, 95880 Enghien-les-Bains (FR)
(72) Inventeur: Krichene, Eslem, 95880 Enghien-les-Bains (FR)

(56) Documents cités:
- CN-A- 107 169 210
- CN-A- 112 948 947
- US-A1- 2009 125 283
- BEACH THOMAS H. ET AL: "Towards the adoption of automated regulatory compliance checking in the built environment", AUTOMATION IN CONSTRUCTION, vol. 118, 1 October 2020 (2020-10-01), AMSTERDAM, NL, XP055959863, ISSN: 0926-5805, DOI: 10.1016/j.autcon.2020.103285

## Description

### Domaine technique

L'invention concerne le domaine de la conception technique des bâtiments et des infrastructures assistées par ordinateur.

L'invention a ainsi plus précisément pour objet un procédé de conception d'ouvrage architectural assistée par ordinateur, un produit-programme et un support de stockage informatique.

### État de l'art antérieur

Lors de la conception d'ouvrages d'architecture, il est maintenant d'usage d'utiliser des outils de conception informatique, tels que les logiciels de Modélisation des Informations du Bâtiment qui sont également connus sous le sigle anglais BIM pour « Building Information Modeling », ci-après logiciels BIM, pour réaliser des maquettes numériques informées, ci-après maquettes numériques , de ces ouvrages réunissant toutes les informations relatifs auxdits ouvrages, ces maquettes étant généralement sous forme de maquettes numériques en trois dimensions informées étant donné qu'elles sont porteuses de données, ci-après maquettes 3D. Lors de la conception de telles maquettes, il est défini différents objets architecturaux de l'ouvrage, tels que les murs extérieurs, les fondations, les planchers, le plafond, les cloisons et les propriétés qui leur sont associées dont notamment les dimensions et les matériaux de ces objets architecturaux.

On notera que par « ouvrage architectural », il est entendu ci-dessus et dans le reste de ce document, tout type de bâtiments ou d'infrastructures susceptibles de faire l'objet d'un plan dans le cadre soit de sa construction soit de sa rénovation soit de sa modification.

On entend par « maquette », ci-dessus et dans le reste de ce document, une représentation géométrique d'un ouvrage, ou d'une partie d'ouvrage définissant les différents objets architecturaux dudit ouvrage ou de ladite partie d'ouvrage, cette maquette pouvant être aussi bien en deux dimensions, représentant par exemple une façade, une coupe ou un plan d'étage dudit ouvrage/ partie d'ouvrage, ci-après maquette 2D, qu'en trois dimensions (maquette 3D). Une telle maquette présente les différents objets architecturaux en y associant leurs propriétés. Ces maquettes sont généralement réalisées à partir d'un logiciel BIM et peuvent être enregistrées sous un format numérique dédié, tel que le format interopérable IFC pour la dénomination anglaise « Industry Foundation Classes ». On notera que dans le cadre du présent document les termes « maquette » et « maquette numérique » sont synonymes et sont parfaitement interchangeables.

On notera que les propriétés associées à un objet architectural de la maquette peuvent être de diverses natures et peuvent notamment être sélectionnées parmi :
- une composition, c'est-à-dire la nature des matériaux composant l'objet architectural de la maquette numérique ;
- une ou plusieurs propriétés telles que par exemple une résistance thermique ou une performance acoustique ou mécanique ;
- une localisation : nom de la pièce, des bâtiments, coordonnées de l'objet architectural de la maquette numérique ;
- une information sémantique telle qu'une description de l'objet architectural, une fiche technique ou encore un lien vers un site du fabricant ;
- une information quantitative telle qu'un volume, une surface, une longueur ou toutes autres quantités associées aux constituants de l'objet architectural ;
- une information comportementale telle qu'un comportement de l'objet architectural vis-à-vis d'un autre objet architectural (par exemple : un mur de pignon est attaché à un toit, si bien qu'en bougeant le toit le mur de pignon le suit).

Par simplification et par extension, il est noté que par « propriété de la maquette » ou « propriétés de la maquette », il est entendu ci-dessus et dans le reste de la présente demande la ou les propriétés des objets architecturaux de la maquette.

Dans le cadre de telles conceptions d'ouvrages d'architecture, lors de l'élaboration de la maquette et du ou des Cahiers des Clauses Techniques Particulières, ci-après CCTP, liés audit ouvrage architectural, la cohérence entre la maquette et le ou les CCTPs est primordiale.

De ce fait, tous les différents corps de métier (architectes, bureaux d'étude, ingénieurs, entreprises, maitres d'ouvrage et maitrises d'œuvre), doivent vérifier régulièrement durant l'avancement des différentes phases du projet, notamment après chaque modification de la maquette, que l'ensemble des objets architecturaux de la maquette et les clauses du CCTP soient cohérents ensemble. Une telle revue de la maquette 3D et du ou des CCTPs est un travail fastidieux qui doit donc faire appel à différents intervenants en fonction des objets architecturaux concernés. De ce fait, il n'est pas rare qu'il reste des incohérences entre les objets architecturaux de la maquette, et le CCTP. De telles incohérences peuvent être préjudiciables quant au déroulement du chantier de construction de l'ouvrage d'architecture, en ce qui concerne la liaison entre les différents corps de métier et la réalisation des travaux eux-mêmes, et peuvent de ce fait engendrer des coûts supplémentaires et des retards de livraison.

Il est rappelé que, conformément à l'entendement de l'homme du métier, qu'un CCTP est un document contractuel, faisant partie de l'ensemble des pièces appelé « cahier des charges » ou « dossier de consultation des entreprises » (plus connu sous le sigle DCE), nécessaire à l'exécution des prestations d'un marché. Un CTTP fixe les dispositions techniques et normatives de chaque marché. Ainsi le ou chaque CCTP exprime des besoins en conformité avec la réglementation et les besoins de la maitrise d'ouvrage. Il détaille les prestations à réaliser, les matériaux et les produits mis en œuvre. Ce document rassemble tous les descriptifs techniques et les textes de référence y afférents. Des procédés de vérifications de plans d'ouvrage sont connus des documents US 2009/125283 A1, CN 112 948 947 A, CN 107 169 210 A et de l'article de T.H.Beach et al. publié dans le journal « Automation in construction » Volume 118 le 1er octobre 2020.

### Exposé de l'invention

L'invention vise à résoudre le problème ci-dessus et a ainsi pour objet la fourniture d'un procédé permettant de simplifier une telle vérification et qui surtout permet de limiter les risques de CCTPs non conformes.

L'invention concerne à cet effet un procédé de conception d'un ouvrage architectural assisté par ordinateur comprenant les étapes suivantes :
E1. fourniture d'une maquette d'ouvrage d'au moins une partie de l'ouvrage sous format électronique correspondant, la maquette d'ouvrage comprenant différents objets architecturaux et les propriétés qui sont associées auxdits objets architecturaux,
le procédé comprend en outre les étapes suivantes :
   E2. fourniture sous format électronique de données d'au moins un Cahier des Clauses Techniques Particulières, dénommé ci-après CCTP, associé à l'ouvrage, le CCTP incluant des données associées à au moins un des objets architecturaux,
   E3. détection par l'ordinateur d'incohérences entre les caractéristiques de l'au moins un des objets architecturaux et les données du CCTP qui lui sont associées,
   E5. affichage des incohérences détectées.

Avec un tel procédé, il est possible d'avoir une vérification en temps réel de la cohérence de la maquette, et plus précisément ses objets architecturaux, et du CCTP. Le CCTP en est donc fiabilisé et autorise une conduite sereine du chantier de l'ouvrage sur la base d'une maquette d'ouvrage et d'un ou de CCTPs parfaitement vérifiés. Il en résulte un gain de temps et de coût pour la conception d'ouvrage architectural ceci quelle que soit la complexité de cet ouvrage. En effet, le procédé selon l'invention permet de plus de favoriser la visibilité des données contenues dans le ou les CCTPs au fur et à mesure de la conception de la maquette ceci durant toutes les phases du projet. Il peut également permettre, comme cela sera discuter en lien avec les caractéristiques optionnelles de l'invention, une meilleure collaboration entre les différents acteurs du projet ceci en autorisant l'assignation de taches aux différents intervenants du projet, la correction des incohérences et le partage de données contrôlées et vérifiées du CCTP , nous obtenons ainsi un CCTP plus fiable et plus précis. Le ou les CCTPs étant fiabilisés, le dossier de consultation des entreprises (ou DCE) et le projet d'ouvrage s'en trouvent également fiabilisés.

On notera que dans le cadre de l'étape E2. de fourniture sous format électronique de données d'au moins un Cahier des Clauses Techniques Particulières, une telle étape peut permettre une intégration des données dans la maquette. De cette manière, la maquette est alors informée à la fois par les propriétés des objets architecturaux qu'elle comporte et à la fois par les données fournies par le ou les CCTPs.

On notera également que l'étape d'affichage peut être multiple sans que l'on sorte de l'invention. En effet, l'affichage des incohérences détectées, seules ou en combinaison avec les propriétés des objets architecturaux et les données du ou des CCTPs, peuvent être utile tout au long de la vérification, la correction et l'export des différentes propriétés et données. Ainsi, comme cela sera discuter ci-après cette étape d'affichage peut être mise en œuvre seule ou en concomitance avec d'autres étapes telles que des étapes E4. d'identification d'un intervenant susceptible de corriger l'incohérence et E6. de correction de la ou des données du CCTP.

Il peut être prévu, après l'étape E3. de détection d'incohérences e, une étape E4. d'identification d'un intervenant susceptible de corriger l'incohérence , l'étape E5. pouvant être préalable, postérieur ou concomitante à l'étape E4. et
lorsque l'étape E4. est préalable à l'étape E5. d'affichage des incohérences détectées, lors de l'étape E5. d'affichage des incohérences détectées il est préférentiellement indiqué au moins un intervenant susceptible de corriger l'incohérence.

Une telle identification, pour chaque incohérence détectée, de l'intervenant à même de corriger la maquette et/ou le CCTP afin de résoudre ladite incohérence, permet un gain temps maximal et une correction plus efficiente. En effet, les différents corps de métier ayant à intervenir sur le chantier ne sont sollicités que pour les objets architecturaux, et les CCTPs des lots qui les concernent et sur lesquels ils ont l'expertise nécessaire.

On notera que cette étape d'identification de l'intervenant (ou d'assignation d'une incohérence à corriger à cet intervenant) permet d'optimiser la collaboration entre chacun des corps de métier ayant à intervenir sur le chantier, puisque chacun des intervenants est à même de savoir quelles sont les incohérences qui le concernent.

Dans une configuration usuelle de l'invention, l'étape E4 d'identification peut se faire par l'intermédiaire d'un cabinet d'Étude gérant l'élaboration de la maquette et du ou des CCTPs, dans le cadre par exemple d'une sous étape préalable d'affichage des différentes incohérences détectées, distincte de l'étape E5. d'affichage, et une sous-étape d'identification par le cabinet d'étude du ou des intervenants susceptibles de corriger l'incohérence.

Il peut être prévu après l'étape E5. d'affichage des incohérences une étape E6. de correction de la ou les données du CCTP et/ou la ou les propriétés de la maquette d'ouvrage pour lesquelles une incohérence a été détectée.

Dans ce cadre l'étape E5. d'affichage peut être configurée pour afficher, à chaque intervenant, uniquement les incohérences qu'il est susceptible de corriger, ainsi, ledit intervenant n'a accès à l'étape E6. qu'aux incohérences qu'il est susceptible de corriger.

La maquette d'ouvrage fournie à l'étape E1. de fourniture d'une maquette d'ouvrage sous format électronique peut être une maquette numérique en trois dimensions préférentiellement générée à partir d'un logiciel de Modélisation des Informations du Bâtiment.

Une telle maquette 3D est particulièrement adaptée pour la mise en place d'un procédé selon l'invention. En effet, cela est particulièrement le cas pour les maquettes générées à partir de logiciels BIM, ces deniers autorisant d'informer les différents objets architecturaux d'une telle maquette. Ainsi, il est possible, conformément à l'invention, d'utiliser une telle possibilité d'information pour permettre d'y intégrer les données du ou des CCTPs.

L'ensemble des étapes peuvent être mises en œuvre à partir d'un logiciel de Modélisation des Informations du Bâtiment.

De tels logiciels, avec leur interface de programmation d'applications (plus connus sous le sigle anglais API), permettent de développer des modules externes qui pourraient être adaptés pour la mise en œuvre d'un procédé selon l'invention. De part cette particularité, ces logiciels sont parfaitement adaptés pour la mise en œuvre d'un procédé selon l'invention. Lors de l'étape de fourniture sous format électronique de données d'au moins un CCTP, le CCTP peut être fourni sur la base de balises permettant d'identifier, pour chacune des données, le ou les objets architecturaux auxquels est associée ladite donnée, ces balises permettant préférentiellement, et en outre d'identifier la ou les propriétés du ou desdits objets architecturaux concernés par ladite donnée.

Il est en outre, après l'étape E2. de fourniture sous format électronique des données de l'au moins un CCTP, prévue une étape E7. d'enregistrement des données du CCTP dans un fichier électronique.

Un tel fichier électronique permet de récupérer les données du CCTP telles que corrigées et ainsi permettre leur exploitation durant toutes les phases du projet ainsi que dans le cadre de la conduite du chantier de l'ouvrage architectural. Notamment, ce CCTP ainsi enregistré, ou exporté, peut être aisément partagé avec les intervenants qui en ont besoin.

Lors de l'étape E7. d'enregistrement des données du CCTP dans un fichier électronique, les données du CCTP sont enregistrées dans le fichier électronique associé à la maquette d'ouvrage, le fichier électronique étant préférentiellement un fichier au format interopérable BCF.

De cette manière, les différents corps d'état peuvent avoir accès en un seul fichier à la fois aux propriétés des objets architecturaux et aux données du ou des CCTPs, ces propriétés et données étant, grâce au procédé selon l'invention, cohérentes entre elles. On notera de plus, lorsque c'est un fichier au format BCF ( l'extension BCF correspondant au sigle anglais BCF pour « BIM Collaboration Format c'est-à-dire format de collaboration BIM ) qui est mis en œuvre, ce fichier présente l'avantage d'être interopérable entre les logiciels BIM.

L'invention concerne en outre un produit programme d'ordinateur comprenant du code information configuré pour mettre en œuvre les étapes d'un procédé de conception d'un ouvrage architectural selon l'invention lorsqu'il est exécuté sur un ordinateur, le produit programme comportant des instructions pour réaliser les étapes suivantes :
- fourniture d'une maquette de l'ouvrage sous format électronique, la maquette comprenant différents objets architecturaux et les propriétés qui sont associées auxdits objets architecturaux,
- fourniture sous format électronique de données d'au moins un Cahier des Clauses Techniques Particulières associées à au moins l'un des objets architecturaux,
- détection par l'ordinateur d'incohérence entre les propriétés de l'au moins l'un des objets architecturaux et les données du Cahier des Clauses Particulières qui lui est associé,
- affichage des incohérences détectées.

Bien entendu, conformément à l'invention, cet affichage peut être utilisé dans le cadre de la présente invention, à la fois pour un simple affichage des incohérences détectées et à la fois dans le cadre des différentes étapes d'assignation et de correction (c'est-à-dire de collaboration) qui peuvent être mises en œuvre dans le cadre du procédé de conception selon l'invention.

Un tel produit-programme permettant la mise en œuvre d'un procédé de conception selon l'invention, il permet d'obtenir les avantages qui y sont associés.

L'invention concerne en outre un support d'enregistrement informatique lisible par un ordinateur stockant le produit-programme selon l'invention.

Un tel support permet de lancer et/ou d'installer un produit-programme selon l'invention et de bénéficier des avantages qui y sont associés.

### Brève description des dessins

La présente invention sera mieux comprise à la lecture de la description d'exemples de réalisation, donnés à titre purement indicatif et nullement limitatif, en faisant référence aux dessins annexés sur lesquels :
- la figure 1 illustre un exemple d'ouvrage architectural tel que susceptible d'être conçu au moyen d'un procédé de conception selon l'invention,
- la figure 2 illustre un ordinogramme d'un procédé de conception selon l'invention,
- la figure 3 illustre une capture d'écran d'un logiciel BIM mettant en œuvre le procédé selon l'invention lors d'une étape de fourniture du CCTP ou des CCTPs, cette étape permettant une importation de ce dernier dans la maquette,
- la figure 4 illustre une capture d'écran du logiciel BIM de la figure 3 après fourniture du CCTP, le logiciel affichant à la fois les propriétés des objets de la maquette relative à un objet architectural, ici le plancher haut, et les données du CCTP relatives à ce même objet architectural qui sont liées entre elles,
- la figure 5 illustre une capture d'écran du logiciel BIM des figures 3 et 4 lors d'une étape de détection par l'ordinateur d'incohérences entre les propriétés des objets de la maquette et des données du CCTP,
- la figure 6 illustre une capture d'écran du logiciel BIM des figures 3 à 5 lors d'une étape d'assignation de vérification de chacune des incohérences détectées à un intervenant respectif ceci afin de permettre une collaboration conforme à l'invention, ce même menu pouvant être utilisé, dans le présent mode de réalisation, par les différents intervenants pour corriger les incohérences détectées qui leur sont assignées,
- la figure 7 illustre une capture d'écran du logiciel BIM des figures 3 à 6 lors d'une étape de correction par chaque intervenant des données de la maquette et/ou du ou des CCTPs afin de corriger les incohérences identifiées,
- la figure 8 illustre une capture d'écran du logiciel BIM des figures 3 à 7 après la correction des incohérences identifiées, l'utilisateur ayant alors la possibilité d'exporter le CCTP corrigé, la maquette ou l'ensemble CCTP/maquette préférentiellement sous des formats interopérables,
- la figure 9 illustre une capture d'écran du logiciel BIM des figures 3 à 8 dans le cadre de l'export d'un CCTP, ici le CCPT gros œuvre, corrigé, la figure 9 montrant, à titre de comparaison, le CCTP gros œuvre initial utilisé dans le cadre de son importation dans la maquette.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### Exposé détaillé de modes de réalisation particuliers

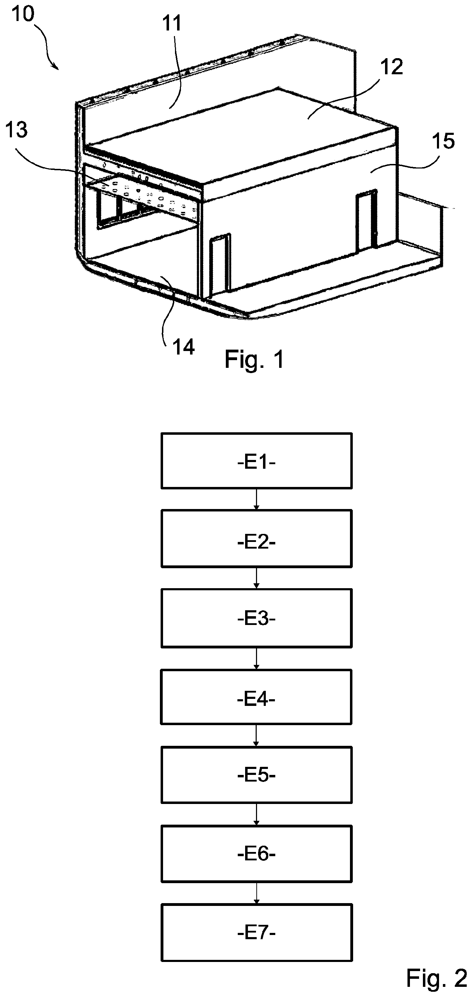

La figure 1 montre un exemple d'ouvrage architectural 10 utilisé pour illustrer le principe d'un procédé de conception d'un ouvrage architectural 10 selon l'invention, ici le la maquette numérique d'une pièce, telle qu'une salle de classe, faisant partie d'un ensemble plus important.

On notera que l'invention concerne plus particulièrement la conception d'ouvrage architectural 10 assisté par ordinateur à base de logiciel BIM, l'invention ne se limite pas à ce seul type de logiciel et peut s'appliquer à tout type de logiciel apte à permettre la conception d'ouvrage assisté par ordinateur ceci sur la base d'une maquette informée, que celle-ci soit à deux dimensions ou à trois dimensions à partir de laquelle il est susceptible d'être extraits des éléments techniques en deux dimensions (plans, coupes , façades). De même, cette conception selon l'invention peut être mise en œuvre à partir d'un logiciel adapté qui présente ainsi toutes les fonctions nécessaires pour la mise en œuvre de l'invention ou au moyen d'un module d'extension, plus connu sous la dénomination anglaise de plugin ou plug-in, associé audit logiciel comme cela est présenté par la suite. Comme le montre la figure 1, le présent ouvrage architectural 10 comprend les objets architecturaux 11, 12, 13, 14, 15 suivants :
- une façade 11,
- un plancher haut 12,
- un faux plafond 13,
- un plancher bas 14,
- une cloison 15.

Bien entendu, il s'agit ici que d'un exemple simplifié des objets architecturaux susceptibles d'être présentés par un ouvrage architectural qui n'est fourni qu'à titre d'illustration du principe de l'invention, un ouvrage architectural, ou une partie d'ouvrage architectural pouvant comporter des objets architecturaux supplémentaires et/ou ne pas comporter certains de ces objets architecturaux. De même, un ouvrage architectural plus complexe, tel qu'un bâtiment à plusieurs étages, peut comporter plusieurs objets architecturaux d'un même type (par exemple un plancher, un type de parois... dédiés à chacun des étages).

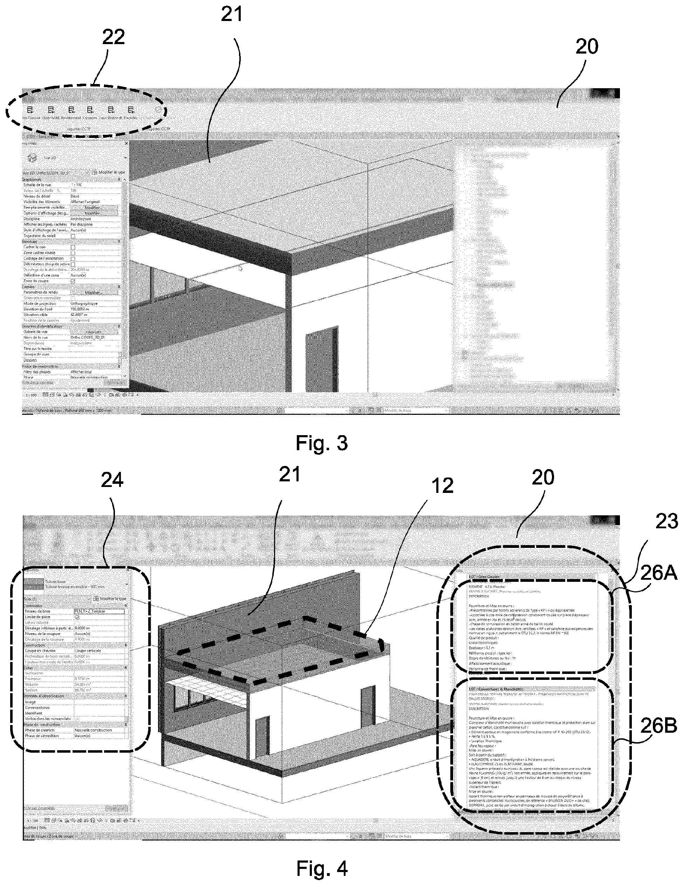

Chacun de ces objets architecturaux 11, 12, 13, 14, 15 présente des propriétés qui peuvent être intégrées dans la maquette 21 afin de l'informer et qui pourront faire l'objet de données d'un CCTP 26A, 26B comme cela sera discuté en lien avec les figures 3 à 8.

Dans le cadre du présent mode de réalisation, l'ouvrage architectural 10 peut être réalisé au moyen d'un logiciel de conception assisté par ordinateur tel qu'un logiciel BIM et se faire au moyen d'un procédé de conception assisté par ordinateur comprenant, conformément à la figure 2 et en référence aux figures 3 à 8, les étapes suivantes :
E1. fourniture d'une maquette d'ouvrage 21 d'au moins une partie de l'ouvrage 10 sous format électronique correspondant, la maquette d'ouvrage 21 comprenant différents objets architecturaux 11, 12, 13, 14, 15 et les propriétés 24 qui sont associées auxdits objets architecturaux 11, 12, 13, 14, 15,
E2. fourniture sous format électronique de données d'au moins un Cahier des Clauses Techniques Particulières 26A, 26B, dénommé ci-après CCTP, associé aux objets de la maquette, chaque CCTP 26A, 26B incluant des données 23 associées à au moins un des objets architecturaux 11, 12, 13, 14, 15,
E3. détection d'incohérences entre les propriétés 24 de l'au moins un des objets architecturaux 11, 12, 13, 14, 15 et les données 23 du CCTP 26A, 26B qui lui sont associées,
E4. identification d'un intervenant susceptible de corriger l'incohérence,
E5. affichage des incohérences détectées, l'intervenant susceptible de corriger l'incohérence étant alors indiqué,
E6. correction de la ou des propriétés de la maquette et/ou données du CCTP détectées comme incohérentes entre elles,
E7. enregistrement des données du CCTP 26A, 26B dans un fichier électronique.

Bien entendu, l'ordre des étapes ci-dessus est donné qu'à titre indicatif et il est possible que certaine de ces étapes soient exécutées en parallèle ou de manière concomitante entre elles. Ainsi, comme cela est discuté ci-après, il est bien entendu possible que l'étape E5. d'affichage soit mis en œuvre avec l'étape E4. d'identification d'un intervenant ou l'étape E6. de correction, l'affichage des incohérences détectées pouvant s'avérer nécessaire dans le cadre de ces étapes E5. et E6..

Dans le cadre de l'étape E2. de fourniture du ou des CCTPs 26A, 26B, chacune des données 23 du ou des CCTPs 26A, 26B peut être intégrée à la maquette d'ouvrage 21 en la liant à ou aux objets auxquels ladite donnée est associée.

On notera que dans le cadre de l'étape E1. de fourniture de la maquette 21, cette fourniture peut se faire soit par une conception directement sur l'ordinateur permettant la mise en œuvre du présent procédé, soit lors d'une importation d'un fichier dans ledit logiciel. De même, le présent procédé peut aussi bien être mis en œuvre à partir d'une maquette 21 complétée, les étapes E2.à E7. étant alors mises en œuvre sur une maquette 21 comprenant l'ensemble de ses objets architecturaux 11, 12, 13, 14, 15, qu'à partir d'une maquette 21 en cours de conception, les étapes E2. à E7. étant alors mises en œuvre à partir des seuls objets architecturaux 11, 12, 13, 14, 15 qui sont compris dans cette maquette 21 partiellement conçue et les propriétés associées audits objets architecturaux 11, 12, 13, 14, 15.

La figure 3 illustre une capture d'écran 20 d'un logiciel BIM dans le cadre de la mise en œuvre de l'étape E2. de fourniture du ou des CCTPs. Dans le présent cas, on peut voir que la maquette 21 a été préalablement fournie (conçue ou importée) et qu'il est prévu plusieurs CCTPs relatifs à différentes dispositions techniques et normatives de l'ouvrage architectural. Ainsi, il est prévu un CCTP pour respectivement :
- le gros œuvre,
- l'étanchéité,
- le revêtement,
- les cloisons,
- les faux-plafonds, et
- la façade.

Ainsi, on peut voir sur la figure 3, l'étape de fourniture du ou des CCTPs 26A, 26B peut être réalisée par une importation des CCTPs 26A, 26B au moyen d'une fonction dédiée dans le logciel BIM. Pour se faire, le ou les CCTPs 26A, 26B peuvent être fournis sous la forme de fichiers, tels que des fichiers texte, comprenant un certain nombre de balises chacune associée à une donnée dédiée. Bien entendu, dans le cadre cette fourniture du ou des CCTPs, il peut également être prévu la possibilité de corriger une partie des données importées.

En variante et selon une possibilité non avantageuse de l'invention, cette fourniture peut également se faire directement par une entrée manuelle des différentes données numériques du ou des CTTPs 26A, 26B dans le logiciel.

Ces différentes données peuvent être associées à différents objets architecturaux. Ainsi, si l'on prend les CCTPs « gros œuvre » indiqué ici sous la référence 26A, « étanchéité » indiqué ici sous la référence 26B, et « façade », certaines des données 23 de ceux-ci vont pouvoir être associées à la façade 11 de l'ouvrage architectural et aux propriétés de cette dernière qui sont informées dans la maquette 21. Bien entendu, dans le cadre du présent procédé, l'association/liaison entre les propriétés de chaque objet architectural 11, 12, 13, 14, 15 et les données 23 des CCTPs 26A, 26B se fait préférentiellement et avantageusement de manière automatisée, lesdites associations/ liaisons ayant été préalablement renseignées. Néanmoins, il est également envisageable que l'association/liaison de toutes ou parties des données 23 puissent être réalisées par un utilisateur dans le cadre de la fourniture du ou des CCTPs 26A, 26B.

Dans le cadre des étapes E1. et E2. de fourniture de la maquette 21 et du ou des CCTPs mises en œuvre, les données 23 du ou des CCTPs 26A, 26B vont pouvoir être associées/liées aux propriétés 24 des différents objets architecturaux 11, 12, 13, 14, 15 et ainsi être intégrées à la maquette 21. C'est cela qui est montré sur la figure 4. On peut en effet voir sur cette figure, la sélection du plancher haut 12 permet de mettre en parallèle les propriétés 24 informées dans la maquette 21 et les données 23 de deux CCTPs 26A, 26B (« gros œuvre » et « étanchéité ») qui sont associées au plancher haut 12 et à ses propriétés 24. Cette première visualisation peut permettre à un utilisateur, tel qu'un intervenant d'un bureau d'étude s'occupant de la conception de la maquette 2, d'identifier des premières incohérences entre les propriétés 24 d'un objet architectural et les données 23 des CCTPs 26A, 26B.

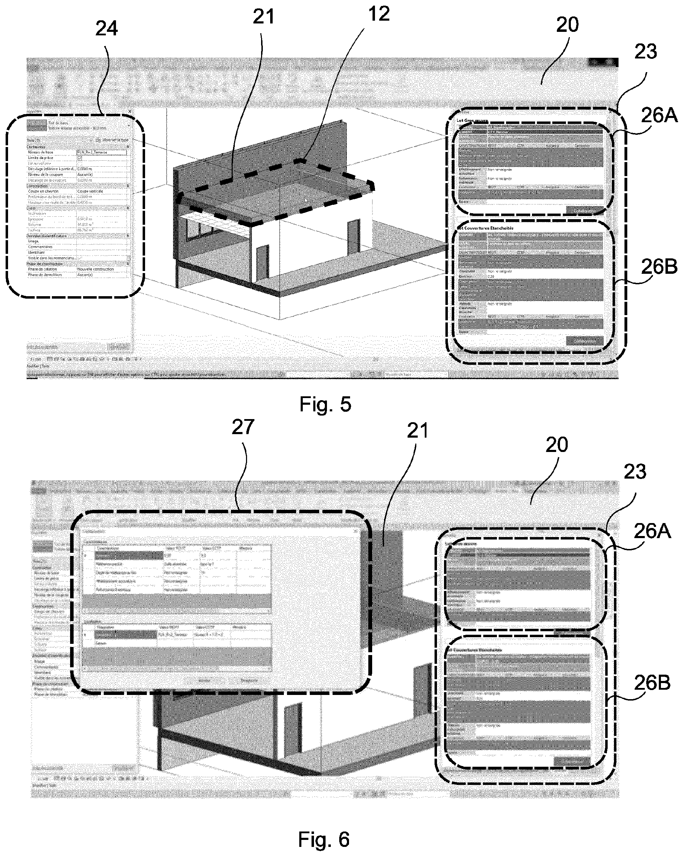

Dans le cadre du procédé, une fois le ou les CCTPs fournis, l'étape E3. de détection par l'ordinateur des incohérences entre les propriétés 24 de l'au moins un des objets architecturaux 11, 12, 13, 14, 15 de la maquette 21 et les données 23 du ou des CCTP qui lui sont associées peut être mise en œuvre. Dans le cadre de cette étape, le logiciel va pouvoir comparer les propriétés 24 des différents objets architecturaux 11, 12, 13, 14, 15 de la maquette 21 avec les données 23 associées du ou des CCTPs 26A, 26B. Selon une première approche du procédé, cette comparaison peut se faire par une vérification d'une correspondance directe entre lesdites propriétés 24 et lesdites données 23. Dans le cadre de cette première approche, toutes différences entre une propriété d'un objet architectural et une donnée du ou des CCTPs sera identifiée par l'ordinateur, au moyen du présent logiciel, comme une incohérence. C'est cette étape de détection qui est illustrée sur la figure 5.

En effet, comme on peut voir sur cette capture d'écran, le logiciel est configuré pour mettre en foncé, par exemple en appliquant une couleur rouge, les données 23 des CCTPs identifiées comme incohérentes avec les propriétés 24 informées des objets architecturaux de la maquette 21, les données 23 identifiées comme cohérentes sont quant à elles mises en claire, par exemple en appliquant une couleur verte. Ainsi si, l'on prend les données 23 du premier CCTPs affiché, on peut voir qu'une majorité des données 23 du premier CCTPs 26A (« gros œuvre ») sont identifiées comme incohérentes.

On notera que, selon une seconde approche, la comparaison entre les propriétés 24 des objets architecturaux 11, 12, 13, 14, 15 et les données 23 du ou des CCTPs 26A, 26B peuvent se faire par une vérification de compatibilité entre les propriétés 24 des objets architecturaux 11, 12, 13, 14, 15 et les données 23 du ou des CCTPs 26A, 26B. En effet, les propriétés 24 de l'objet architectural 11, 12, 13, 14, 15 et les données 23 prévues dans le ou les CCTPs 26A, 26B ne présentent pas nécessairement une correspondance exacte. Ainsi, il peut être prévu l'utilisation d'une base de données permettant de vérifier qu'une propriété 24 d'un objet architectural 11, 12, 13, 14, 15 soit bien compatible avec une ou plusieurs données 23 du ou des CCTPs 26A, 26B. Une incohérence peut être détectée lorsqu'une propriété 24 d'un objet architectural sera identifiée par l'ordinateur comme non compatible ou potentiellement non compatible avec une donnée 23 du ou des CCTPs 26A, 26B.

Dans le cadre de cette deuxième approche, la détection des incohérences peut également être basée sur un apprentissage à base d'intelligence artificielle, celle-ci ayant été préalablement entraînée à partir d'une base de données d'incohérence pour identifier les incohérences les propriétés 24 des objets architecturaux 11, 12, 13, 14, 15 de la maquette 21 et les données 23 du CCTPs 26A, 26B. Cette même intelligence artificielle peut également être entraînée pour permettre un classement par lot des incohérences afin d'en faciliter le traitement et afin de faciliter l'identification du ou des intervenants le ou les plus pertinents.

De même, dans le cadre d'une telle étape E3. de détection d'incohérence, il peut également être prévu la détection de données et/ou de propriétés non renseignées. Lors d'une telle détection, il peut alors être prévu une proposition d'ajout de ladite donnée ou propriété non renseignée.

Une fois la ou les incohérences détectées, il peut être prévu une étape E4. d'identification d'un ou plusieurs intervenants susceptibles de corriger l'incohérence détectée. Cette identification de l'intervenant peut être automatisée, le logiciel comprenant une base de données identifiant en fonction de la propriété et/ou donnée concernée l'intervenant le plus pertinent pour corriger cette incohérence. Néanmoins, en variante, ceci afin de s'assurer la bonne identification de l'interlocuteur pertinent, l'identification de l'intervenant peut être réalisée par un utilisateur du logiciel lors d'une sous-étape d'affichage des différentes incohérences détectées (de préférence étape de collaboration ), distincte de l'étape E5. d'affichage. De même, selon une autre variante, le logiciel peut être configuré pour faire une ou plusieurs propositions d'intervenants devant être validées par l'utilisateur du logiciel, l'utilisateur validant ou corrigeant la proposition faite par le logiciel.

La figure 6 illustre, dans le cadre d'une telle étape E4. d'identification d'un ou plusieurs intervenants susceptibles de corriger l'incohérence détectée, l'ouverture d'une fenêtre 27 dans laquelle est identifiée une ou plusieurs incohérences détectées et où l'utilisateur est à même de corriger ces erreurs et de renseigner le ou lesdits intervenants afin de coordonner la collaboration entre ces derniers.

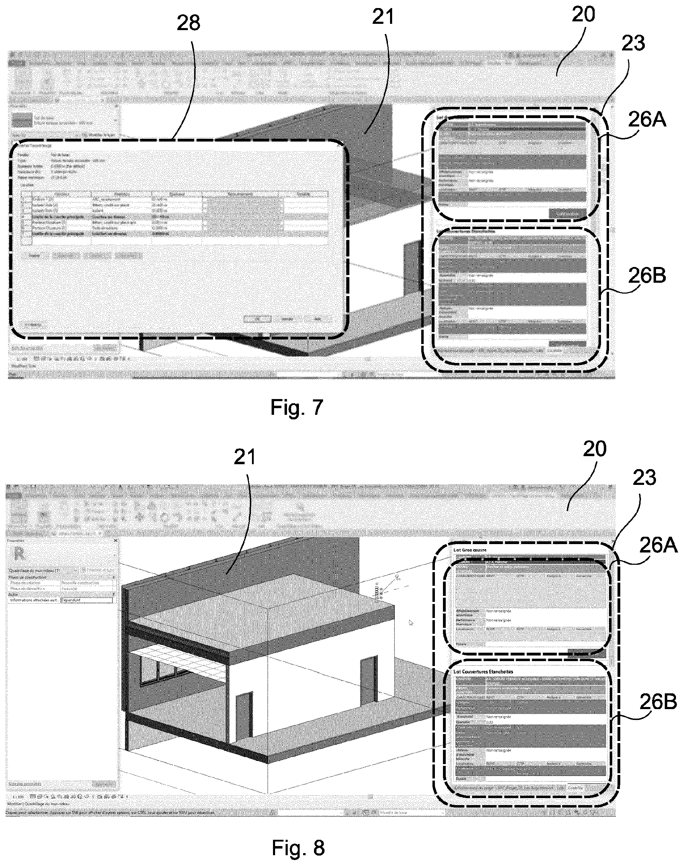

Comme déjà indiqué, l'étape E5. d'affichage des incohérences peut être concomitante d'au moins l'une des étapes E4. d'identification d'un ou plusieurs intervenants susceptibles de corriger l'incohérence détectée et E6. de correction de la ou des propriétés de la maquette et/ou données du CCTP détectées comme incohérentes entre elles. En effet, dans le cadre d'une telle identification et d'une telle correction, il peut être opportun d'afficher lesdites incohérences, comme cela est montré sur les figures 6 et 7. De même, cette étape E5. d'affichage des incohérences peut également être réalisée préalablement à ces deux étapes comme cela est montré sur la figure 5, les incohérences étant identifiées, comme discuté en lien avec cette figure, par un code couleur. De même, il est parfaitement envisageable que l'étape E4. comprenne une sous-étape d'affichage préalable de chaque incohérence pour permettre d'identifier l'intervenant pertinent pour la corriger et que l'étape E5. d'affichage en tant que telle soit mise en œuvre dans le cadre de l'étape E6. de correction, les incohérences étant alors affichées afin de permettre leur correction par chaque intervenant identifié.

Lors de l'étape E6. de correction de la ou des propriétés 24 de la maquette 21 et/ou données 23 du ou des CCTPs 26A, 26B détectées comme incohérentes, celle-ci peut se faire, comme montré sur la figure 7 par l'intermédiaire d'une fenêtre dédiée 27 à la collaboration qui s'ouvre lorsqu'un intervenant identifié prend la main sur le logiciel et clique sur la fonction dédiée (bouton collaboration) . Selon une possibilité du présent procédé, il est envisageable de prévoir un avertissement du ou des intervenants, par exemple par une notification logicielle ou par l'envoi d'un courriel, afin de l'informer ou les informer de la détection d'une incohérence et du fait qu'elle doit être traitée par leur soin. Selon cette possibilité, le ou les intervenants peuvent recevoir un lien leur donnant accès à tout ou partie de la maquette 21 et aux propriétés et données associées à cette dernière et leur permettant d'effectuer la correction de la ou des propriétés 24 de la maquette 21 et/ou données 23 du ou des CCTPs 26A, 26B.

D'une manière similaire, l'étape E6. peut être mise en œuvre par un envoi ou un partage d'un ou plusieurs fichiers, tels qu'un fichier de la maquette au format IFC et un fichier au format interopérable BCF , correspondant à la maquette 21 informée et aux données du ou des CCTPs et incluant les informations relatives aux incohérences détectées et les intervenants identifiés. De cette manière, lorsque ledit intervenant ouvre ledit fichier, il accède aux informations nécessaires pour effectuer la correction. Bien entendu, selon une possibilité de l'invention, il est envisageable que ce ou ces fichiers soient protégés de telle manière que l'intervenant ne soit à même de corriger que les propriétés 24 et les données 23 pour lesquelles il a été identifié comme intervenant susceptible de corriger l'incohérence.

Afin d'illustrer le principe d'identification de l'intervenant et de correction, il est fourni ci-après un exemple de tableau qui pourra être susceptible d'être utilisé dans le cadre des étapes E4. d'identification d'un intervenant et E6. de correction de la ou des propriétés de la maquette et/ou données du CCTP. On peut voir dans ce tableau que le CCTP concerné est le CCTP « gros œuvre » 26A et les incohérences identifiées concerne plus particulièrement la partie concernant la superstructure et plus spécifiquement le plancher haut 12 qui est ici fourni sous forme de dalles. Les propriétés de la maquette précisent que ce plancher présente une épaisseur de 0,2 cm, qu'il correspond à la référence produit KP1 et qu'il présente un degré de résistance au feu 1H. Les données du CCTP indiquent par contre que ce plancher présente une épaisseur de 0,3 cm, ce qui n'est pas cohérent avec les propriétés de l'objet plancher haut 12 de la maquette 21, les autres données étant cohérentes. On note qu'aucun de la maquette 21 et du CCTP 26A ne précise de valeur en ce qui concerne l'affaiblissement acoustique et les performances thermiques.

Ainsi, la comparaison entre les propriétés 24 de l'objet architectural 12 et les données 23 du CCTP 26A, il peut être identifié une incohérence en ce qui concerne l'épaisseur du plancher et que les informations concernant l'affaiblissement acoustique et les performances thermiques sont manquantes. Une fois les incohérences identifiées dans le cadre de l'étape E4., les intervenants aptes à corriger les incohérences identifiées, et ici à compléter les informations manquantes, peuvent être identifiés dans la colonne Assignation. Ainsi, pendant l'étape E6, la correction d'incohérence d'épaisseur pour le plancher est confiée, avec l'information concernant l'affaiblissement acoustique, à l'ingénieur structure. L'information des performances thermiques est confiée au thermicien. Une fois résolue (et les informations complétées) l'incohérence identifiée, ici en corrigeant la propriété 24 de la maquette 21, la maquette 21 et le CCTP 26A sont cohérents (couleur claire) et rien ne s'oppose à la conduite du chantier.

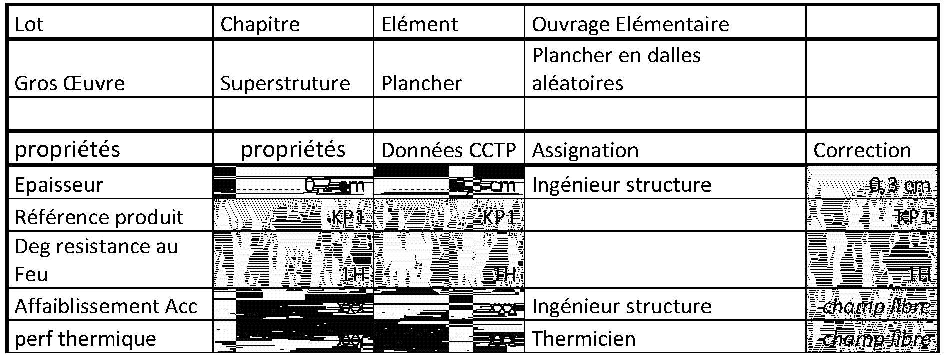

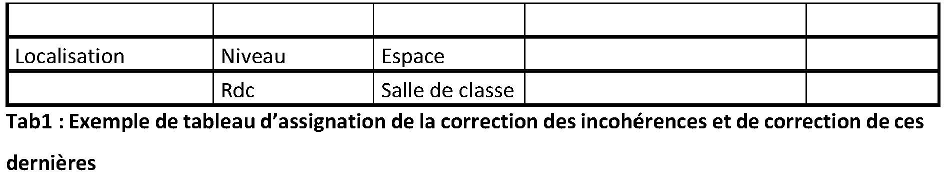

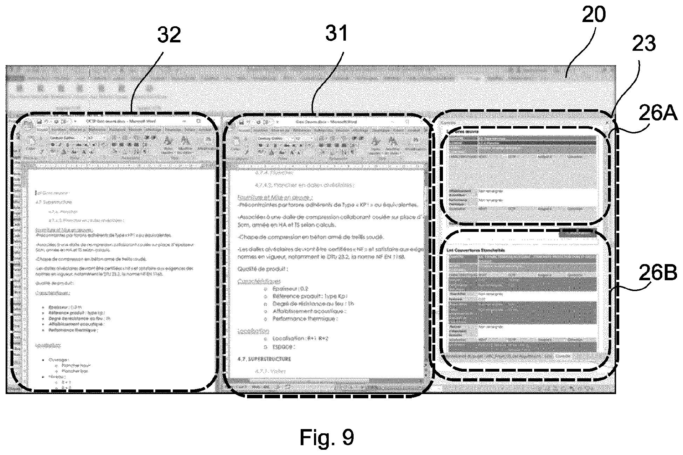

Une fois la ou les propriétés des objets architecturaux de la maquette et/ou données corrigées et complétées et la ou les incohérences résolues comme cela est montré sur la figure 8 pour les données 23 du premier CCTP 26A (les données 23 sont toutes passées en claire), les données et la maquette corrigées peuvent être enregistrées afin de permettre une consultation ultérieure et un partage avec les différents corps de métier intervenants dans le cadre des études et du chantier associé à l'ouvrage architectural. Un tel enregistrement est montré sur la figure 9 sur laquelle est montré, sous la forme d'un fichier word^{™} le CCTP « gros œuvre » corrigé 31 tel qu'exporté dans le cadre de l'invention. À titre de comparaison, le CCTP « gros œuvre » initial 32 est montré sur cette même figure 9.

Si bien entendu et d'une manière préférentielle, chacun du ou des CCTPs 26A, 26B et de la maquette 21 peut être enregistré dans un fichier dédié, dans le cadre du présent procédé de conception, il est également envisageable que la maquette 21 et le ou les CCTPs 26A, 26B soient enregistrés dans un fichier commun.

Dans le présent mode de réalisation dans lequel le procédé est mis en œuvre à partir d'un logiciel BIM, la maquette 21 peut être enregistrée dans un fichier interopérable au format IFC tandis que les CCTPs peuvent être enregistrés ensemble dans un fichier interopérable tel qu'un fichier au format BCF, on notera néanmoins que dans une première mise en œuvre le ou les CCTPs peuvent être enregistrés dans un fichier word^{™} ou excel^{™} sur la base de « balises ».

On notera de plus qu'un tel procédé selon l'invention, en donnant la possibilité de lier la maquette 21 et le ou les CCTPs 26A, 26B permet non seulement de détecter les incohérences, de les suivre, et de les corriger, mais autorise également l'export du ou des CCTPs 26A, 26B via un format word^{™}, excel^{™} ou un format interopérable. Ce type de format, s'il s'agit du format BCF, est lisible et exploitable par les plateformes collaboratives et autres logiciels afin de pouvoir retrouver et proposer une mise à jour du ou des CCTPs sur n'importe quel logiciel par l'intermédiaire d'un identifiant (ID). Il permet ainsi d'envisager de remplacer à moyen terme le CCTP par un fichier BCF contractuel.

Ainsi, si aujourd'hui dans le cadre d'un tel procédé selon l'invention, il est possible d'enregistrer un document au format Word^{™} ou Excel^{™}, il est parfaitement envisageable de mettre en œuvre un tel procédé sur la base du format BCF. Cela devrait permettre de pouvoir alimenter le CCTP qui est au format Word à partir d'un fichier BCF qui sera la vraie passerelle grâce à son interopérabilité.

Un tel procédé permet donc de prévoir un volet collaboratif directement intégré au sein d'un logiciel BIM (ou au plugin) afin d'assurer une meilleure coordination et communication entre les différents corps de métier.

Ainsi, dans le cadre du présent procédé, il est parfaitement envisageable que les incohérences détectées soient listées par lot et/ou type

En effet ce n'est pas le tout d'avoir détecté ces incohérences, il faut également les identifier, les lister par lot, les assigner pour ensuite les suivre dans un cadre de process de gestion de qualité.

De ce fait, la valeur intrinsèque du présent procédé ne réside pas uniquement dans la détection des incohérences, elle en découle également du fait que, au-delà de cette détection, il autorise un traitement de ces incohérences détectées afin de mieux les assignés et favoriser la coopération entre les corps de métier.

C'est ce qui va faire que notre outil s'insérera bel et bien dans un process de gestion de qualité. Un tel procédé est un outil d'analyse qui va générer la visibilité intérieure des données des CCTP qui réalimentent au fur et à mesure le système d'information de la maquette numérique à fin d'obtenir les meilleurs résultats possibles du projet. Grâce à ce process, il est ainsi possible de réagir rapidement et de manière adéquate aux incohérences constatées.

Les CCTP sont donc cohérents et sans erreurs et vont permettre une meilleure qualité du DCE (dossier de consultation des entreprises) pour les Entreprises, ce qui résulte en un gain en temps et en des économies dans la conduite des chantiers.

Si de manière préférentielle, un tel procédé de conception d'ouvrage architectural assisté par ordinateur peut être mis en œuvre au moyen d'un module externe associé au logiciel BIM utilisé pour la conception de la maquette 21, l'invention ne se limite pas à cette seule possibilité. Ainsi, en variante, le logiciel BIM peut être configuré afin de mettre en œuvre un tel procédé de conception et ainsi permettre, conformément à l'invention, une intégration du ou des CCTPs 26A, 26B dans la maquette et la détection d'incohérence entre les propriétés 24 des objets architecturaux 011, 12, 13, 14, 15 de la maquette 21 et les données 23 du ou des CCPTs 26A, 26B. De même, il est également envisageable, sans que l'on sorte du cadre de l'invention, que certaines étapes, telles que l'étape E6. de correction soient réalisées à partir d'un autre logiciel que le logiciel BIM utilisé pour la conception de la maquette. Il est en effet parfaitement envisageable, sans que l'on sorte du cadre de l'invention, de prévoir un logiciel dédié à la collaboration entre les différents intervenants ou encore de prévoir l'export d'un fichier allégé dédié à l'étape de correction, l'intervenant identifié ayant alors à sa disposition uniquement les données/ propriétés nécessaires pour permettre de résoudre l'incohérence identifiée.

On notera que l'invention concerne en outre également un produit programme d'ordinateur comprenant du code information configuré pour mettre en œuvre les étapes d'un procédé de conception d'un ouvrage architectural selon l'invention lorsqu'il est exécuté sur un ordinateur, le produit programme comportant des instructions pour réaliser les étapes suivantes :
- fourniture d'une maquette de l'ouvrage sous format électronique, la maquette comprenant différents objets architecturaux et les propriétés qui sont associées auxdits objets architecturaux,
- fourniture sous format électronique de données d'au moins un Cahier des Clauses Techniques Particulières associées à au moins l'un des objets architecturaux,
- détection d'incohérence entre les propriétés de l'au moins l'un des objets architecturaux et les données du Cahier des Clauses Particulières qui lui est associé,
- affichage des incohérences détectées.

L'invention concerne également un support d'enregistrement informatique lisible par un ordinateur stockant le produit-programme selon l'invention.

## Revendications

1. Procédé de conception d'un ouvrage architectural (10) destiné à être construit assisté par ordinateur, comprenant une pluralité d'objets architecturaux et des propriétés associées à chacun desdits objets, le procédé étant **caractérisé en ce qu'**il comprend les étapes suivantes :
E1. fourniture d'une maquette (21) d'ouvrage d'au moins une partie de l'ouvrage architectural (10) sous format électronique correspondant, la maquette (21) d'ouvrage comprenant plusieurs objets architecturaux (11 mur Extérieur, 12 Toiture, 13 Faux plafond, 14 Plancher bas , 15 Cloison) et les propriétés (24 : Epaisseur, degrés de résistance au feu, affaiblissement acoustique, référence produits , performance thermique, localisation) qui sont associées auxdits objets architecturaux (11, 12, 13, 14, 15), le procédé étant **caractérisé en ce qu'**il comprend en outre les étapes suivantes :
E2. fourniture sous format électronique de données d'au moins un Cahier des Clauses Techniques Particulières (26A CCTP du Lot Gros œuvres, 26B CCTP du lot Etanchéité), dénommé ci-après CCTP, associé à l'ouvrage, le CCTP incluant des données organisées de manière à permettre une association automatisée entre lesdites données et les objets architecturaux (11,12,13,14,15) de la maquette numérique (21) ainsi que les propriétés (24) associées auxdits objets architecturaux.
E3. Détection, par l'ordinateur, d'une incompatibilité de données entre les propriétés (24) de l'au moins un des objets architecturaux (11, 12, 13, 14, 15) de la maquette numérique et les données (23) du CCTP (26A, 26B)-qui lui sont associées, L'étape E3 comprend une sous étape, impliquant la consultation d'au moins une base de données afin de déterminer une correspondance entre les propriétés de chaque objet architectural et les données des CCTP associés à ces objets, et réalisation d'une vérification, à partir de cette correspondance, de la compatibilité entre les propriétés (24) de chaque objet architectural de la maquette (11,12,13,14,15) et les données (23) du CCTP (26A,26B), une incohérence étant détectée lorsqu'une propriété d'au moins un des objets architecturaux (11 ,12,13,14,15) est identifiée par l'ordinateur comme étant non compatible ou potentiellement non compatible avec une donnée (23) du CCTP (26A,26B) associés.
E4. identification d'au moins un intervenant susceptible de corriger l'incohérence détectée.
E5. Affichage des incohérences détectées, l'étape E5. pouvant être préalable, postérieure ou concomitante à l'étape E4. Et dans lequel, lorsque l'étape E4. est préalable à l'étape E5., l'au moins un intervenant susceptible de corriger l'incohérence est indiqué lors de l'étape E5.
E6. correction de la ou des données (23) du CCTP (26A, 26B) et/ou de la ou des propriétés des objets de la maquette (21) d'ouvrage pour lesquelles une incohérence a été détectée.

2. Procédé de conception d'un ouvrage architectural (10) selon la revendication 1, dans lequel la maquette (21) d'ouvrage fournie à l'étape E1. de fourniture d'une maquette (21) d'ouvrage sous format électronique est une maquette numérique en trois dimensions préférentiellement générée à partir d'un logiciel de Modélisation des Informations du Bâtiment.

3. Procédé de conception d'un ouvrage architectural (10) selon l'une quelconque des revendication 1 à 2 dans lequel l'ensemble des étapes sont mises en œuvre à partir d'un logiciel de Modélisation des Informations du Bâtiment.

4. Procédé de conception d'un ouvrage architectural (10) selon l'une quelconque des revendications 1 à 3, dans lequel lors de l'étape de fourniture sous format électronique de données d'au moins un CCTP, le CCTP est fourni sur la base de balises permettant d'identifier, pour chacune des données, le ou les objets architecturaux (11, 12, 13, 14, 15) auxquels est associée ladite donnée, ces balises permettant préférentiellement, et en outre, d'identifier la ou les propriétés du ou desdits objets architecturaux concernés par ladite donnée.

5. Procédé de conception d'un ouvrage architectural (10) selon l'une quelconque des revendications 1 à 4, dans lequel il est en outre, après l'étape E2. de fourniture sous format électronique des données de l'au moins un CCTP, prévu une étape E7. d'enregistrement des données du CCTP dans un fichier électronique.

6. Procédé de conception d'un ouvrage architectural (10) selon la revendication 5, dans lequel lors de l'étape E7. d'enregistrement des données du CCTP dans un fichier électronique, les données du CCTP sont enregistrées dans le fichier électronique avec la maquette (21) d'ouvrage, le fichier électronique étant préférentiellement un fichier au format BCF.

7. Produit-programme d'ordinateur comprenant des instructions qui, lorsque le programme est exécuté par un ordinateur, amènent l'ordinateur à mettre en œuvre les étapes du procédé selon l'une quelconque des revendications 1 à 6.

8. Support d'enregistrement informatique lisible par ordinateur comprenant des instructions qui, lorsqu'elles sont exécutées par un ordinateur, amènent l'ordinateur à mettre en œuvre les étapes du procédé selon l'une quelconque des revendications 1 à 6.

## Patentansprüche

1. Computerunterstütztes Verfahren zum Entwerfen eines zu errichtenden architektonischen Bauwerks (10), umfassend eine Vielzahl von architektonischen Objekten und Eigenschaften, die jedem der genannten Objekte zugeordnet sind, wobei das Verfahren **dadurch gekennzeichnet ist, dass** es die folgenden Schritte umfasst:
E1. Bereitstellen eines Bauwerksmodells (21) zumindest eines Teils des architektonischen Bauwerks (10) in einem entsprechenden elektronischen Format, wobei das Bauwerksmodell (21) mehrere architektonische Objekte (11 Außenwand, 12 Dach, 13 abgehängte Decke, 14 Bodenplatte, 15 Trennwand) und die Eigenschaften (24: Dicke, Feuerwiderstandsgrad, Schalldämmung, Produktreferenz, Wärmeleistung, Lage) umfasst, die den genannten architektonischen Objekten (11, 12, 13, 14, 15) zugeordnet sind, wobei das Verfahren **dadurch gekennzeichnet ist, dass** es ferner die folgenden Schritte umfasst:
E2. Bereitstellen, in elektronischem Format, von Daten mindestens eines Dokuments mit besonderen technischen Vertragsbedingungen (26A CCTP des Rohbau-Loses, 26B CCTP des Abdichtungs-Loses), im Folgenden als CCTP bezeichnet, das dem Bauwerk zugeordnet ist, wobei das CCTP Daten enthält, die derart organisiert sind, dass eine automatisierte Zuordnung zwischen den genannten Daten und den architektonischen Objekten (11, 12, 13, 14, 15) des digitalen Modells (21) sowie den genannten architektonischen Objekten zugeordneten Eigenschaften (24) ermöglicht wird.
E3. Erkennen, durch den Computer, einer Dateninkompatibilität zwischen den Eigenschaften (24) mindestens eines der architektonischen Objekte (11, 12, 13, 14, 15) des digitalen Modells und den diesem zugeordneten Daten (23) des CCTP (26A, 26B), wobei Schritt E3 einen Unterschritt umfasst, der das Abfragen mindestens einer Datenbank beinhaltet, um eine Entsprechung zwischen den Eigenschaften jedes architektonischen Objekts und den Daten der diesen Objekten zugeordneten CCTPs zu bestimmen, und wobei auf der Grundlage dieser Entsprechung eine Überprüfung der Kompatibilität zwischen den Eigenschaften (24) jedes architektonischen Objekts des Modells (11, 12, 13, 14, 15) und den Daten (23) des CCTP (26A, 26B) durchgeführt wird, wobei eine Inkonsistenz erkannt wird, wenn eine Eigenschaft mindestens eines der architektonischen Objekte (11, 12, 13, 14, 15) durch den Computer als mit einem Datum (23) des zugeordneten CCTP (26A, 26B) nicht kompatibel oder potenziell nicht kompatibel identifiziert wird.
E4. Identifizieren mindestens eines Beteiligten, der in der Lage ist, die erkannte Inkonsistenz zu korrigieren.
E5. Anzeigen der erkannten Inkonsistenzen, wobei Schritt E5 vor, nach oder gleichzeitig mit Schritt E4 erfolgen kann, und wobei, wenn Schritt E4 vor Schritt E5 erfolgt, der mindestens eine Beteiligte, der in der Lage ist, die Inkonsistenz zu korrigieren, während Schritt E5 angegeben wird.
E6. Korrigieren der Daten (23) des CCTP (26A, 26B) und/oder der Eigenschaften der Objekte des Bauwerksmodells (21), für die eine Inkonsistenz erkannt wurde.

2. Verfahren zum Entwerfen eines architektonischen Bauwerks (10) nach Anspruch 1, wobei das in Schritt E1 bereitgestellte Bauwerksmodell (21) in elektronischem Format ein dreidimensionales digitales Modell ist, das vorzugsweise mittels einer Software zur Bauwerksdatenmodellierung (Building Information Modelling) erzeugt wird.

3. Verfahren zum Entwerfen eines architektonischen Bauwerks (10) nach einem der Ansprüche 1 bis 2, wobei sämtliche Schritte mittels einer Software zur Bauwerksdatenmodellierung (Building Information Modelling) durchgeführt werden.

4. Verfahren zum Entwerfen eines architektonischen Bauwerks (10) nach einem der Ansprüche 1 bis 3, wobei beim Schritt des Bereitstellens von Daten mindestens eines CCTP in elektronischem Format das CCTP auf der Grundlage von Kennzeichnungen bereitgestellt wird, die es ermöglichen, für jedes Datenelement das oder die architektonischen Objekte (11, 12, 13, 14, 15) zu identifizieren, denen das betreffende Datenelement zugeordnet ist, wobei diese Kennzeichnungen vorzugsweise ferner ermöglichen, die Eigenschaft oder Eigenschaften des oder der genannten architektonischen Objekte zu identifizieren, auf die sich das betreffende Datenelement bezieht.

5. Verfahren zum Entwerfen eines architektonischen Bauwerks (10) nach einem der Ansprüche 1 bis 4, wobei ferner nach Schritt E2 des Bereitstellens der Daten des mindestens einen CCTP in elektronischem Format ein Schritt E7 des Speicherns der CCTP-Daten in einer elektronischen Datei vorgesehen ist.

6. Verfahren zum Entwerfen eines architektonischen Bauwerks (10) nach Anspruch 5, wobei beim Schritt E7 des Speicherns der CCTP-Daten in einer elektronischen Datei die CCTP-Daten zusammen mit dem Bauwerksmodell (21) in der elektronischen Datei gespeichert werden, wobei die elektronische Datei vorzugsweise eine Datei im BCF-Format ist.

7. Computerprogrammprodukt, umfassend Anweisungen, die, wenn das Programm von einem Computer ausgeführt wird, den Computer veranlassen, die Schritte des Verfahrens nach einem der Ansprüche 1 bis 6 auszuführen.

8. Computerlesbares Speichermedium, umfassend Anweisungen, die, wenn sie von einem Computer ausgeführt werden, den Computer veranlassen, die Schritte des Verfahrens nach einem der Ansprüche 1 bis 6 auszuführen.

## Claims

1. Computer-assisted method for designing an architectural structure (10) intended to be constructed, comprising a plurality of architectural objects and properties associated with each of said objects, the method being **characterised in that** it comprises the following steps:
E1. providing, in electronic format, a structure model (21) corresponding to at least part of the architectural structure (10), the structure model (21) comprising several architectural objects (11 exterior wall, 12 roof, 13 suspended ceiling, 14 floor slab, 15 partition wall) and the properties (24: thickness, fire-resistance rating, sound reduction, product reference, thermal performance, location) associated with said architectural objects (11, 12, 13, 14, 15),
the method being **characterised in that** it further comprises the following steps:
E2. providing, in electronic format, data from at least one Particular Technical Specifications document (26A CCTP for the structural works package, 26B CCTP for the waterproofing package), hereinafter referred to as CCTP, associated with the structure, the CCTP including data organised so as to enable an automated association between said data and the architectural objects (11, 12, 13, 14, 15) of the digital model (21), as well as the properties (24) associated with said architectural objects.
E3. detecting, by the computer, a data incompatibility between the properties (24) of at least one of the architectural objects (11, 12, 13, 14, 15) of the digital model and the data (23) of the CCTP (26A, 26B) associated therewith, step E3 comprising a sub-step involving consulting at least one database in order to determine a correspondence between the properties of each architectural object and the data of the CCTPs associated with those objects, and carrying out, on the basis of said correspondence, a verification of the compatibility between the properties (24) of each architectural object of the model (11, 12, 13, 14, 15) and the data (23) of the CCTP (26A, 26B),
an inconsistency being detected when a property of at least one of the architectural objects (11, 12, 13, 14, 15) is identified by the computer as being incompatible or potentially incompatible with data (23) of the associated CCTP (26A, 26B).
E4. identifying at least one stakeholder capable of correcting the detected inconsistency.
E5. displaying the detected inconsistencies, step E5 being capable of taking place before, after or concurrently with step E4, and
wherein, when step E4 takes place before step E5, the at least one stakeholder capable of correcting the inconsistency is indicated during step E5.
E6. correcting the data (23) of the CCTP (26A, 26B) and/or the properties of the objects of the structure model (21) for which an inconsistency has been detected.

2. Method for designing an architectural structure (10) according to claim 1, wherein the structure model (21) provided in step E1 of providing a structure model (21) in electronic format is a three-dimensional digital model, preferably generated using Building Information Modelling software.

3. Method for designing an architectural structure (10) according to any one of claims 1 to 2, wherein all of the steps are implemented using Building Information Modelling software.

4. Method for designing an architectural structure (10) according to any one of claims 1 to 3, wherein, during the step of providing data from at least one CCTP in electronic format, the CCTP is provided on the basis of tags enabling, for each item of data, identification of the architectural object or objects (11, 12, 13, 14, 15) with which said item of data is associated, said tags preferably further enabling identification of the property or properties of said architectural object or objects concerned by said item of data.

5. Method for designing an architectural structure (10) according to any one of claims 1 to 4, wherein, after step E2 of providing, in electronic format, the data of the at least one CCTP, a step E7 of recording the CCTP data in an electronic file is further provided.

6. Method for designing an architectural structure (10) according to claim 5, wherein, during step E7 of recording the CCTP data in an electronic file, the CCTP data are recorded in the electronic file together with the structure model (21), the electronic file preferably being a file in BCF format.

7. Computer program product comprising instructions which, when the program is executed by a computer, cause the computer to carry out the steps of the method according to any one of claims 1 to 6.

8. Computer-readable storage medium comprising instructions which, when executed by a computer, cause the computer to carry out the steps of the method according to any one of claims 1 to 6.
